# EUROPEAN PATENT SPECIFICATION

(11) **EP 3 471 186 B1**
(45) Date of publication and mention of the grant of the patent: **25.03.2020**
(21) Application number: 17196504.9
(22) Date of filing: 16.10.2017
(51) Int. Cl.: H01M 10/04, H01M 10/052, H01M 10/0587, H01M 10/42, H01M 10/48, G01R 31/36

(54) **BATTERY SYSTEM WITH BATTERY CELL INTERNAL CELL SUPERVISION CIRCUITS**
BATTERIESYSTEM MIT BATTERIEZELLEN MIT INTERNEN ZELLENÜBERWACHUNGSSCHALTUNGEN
SYSTÈME DE BATTERIE AVEC CIRCUITS INTERNES DE SUPERVISION DE CELLULE DE BATTERIE

(43) Date of publication of application: 17.04.2019
(73) Proprietor: Samsung SDI Co., Ltd., Yongin-si, Gyeonggi-do 17084 (KR)
(72) Inventor: Erhart, Michael, 8054 Seiersberg-Pirka (AT); Proßnigg, Florian, 8047 Graz (AT)
(74) Representative: Gulde & Partner

(56) References cited:
- WO-A1-2014/204649
- DE-C1- 19 605 481
- US-A1- 2005 121 979
- US-A1- 2009 273 317
- US-A1- 2010 072 975
- US-A1- 2012 112 706

## Description

### Field of the Invention

The present invention relates to a battery system which comprises two system terminals for the connection to a load, respectively. The battery system further comprises a plurality of battery cells, each battery cell comprising two cell terminals electrically connected to one of the two system terminals via one of two power lines, respectively. Moreover, at least some of the battery cells further comprise an internal cell supervision circuit, iCSC, arranged within said battery cells respectively, wherein each of the iCSCs is adapted to detect at least one parameter of the battery cell it is arranged in. The battery system further comprises a battery management system, BMS, connected to the two power lines, the BMS being adapted to communicate bidirectionally with the iCSCs via the power lines.

### Technological Background

A rechargeable or secondary battery or battery system differs from a primary battery or battery system in that it can be repeatedly charged and discharged, while the latter provides only an irreversible conversion of chemical to electrical energy. Low-capacity rechargeable batteries or battery systems are used as power supply for small electronic devices, such as cellular phones, notebook computers and camcorders, while high-capacity rechargeable batteries or battery systems are used as the power supply for hybrid vehicles and the like.

In most battery systems of the state of the art, the cell voltages and temperatures of the battery cells have to be measured among others for safety reasons. Hence, it is common to provide battery systems with so called cell supervision circuits, CSCs, that are often provided on printed circuit boards, PCBs, and adapted to carry out the aforementioned measurements. Via the CSCs, it is possible to measure among others the battery cell voltages and temperatures of up to 24 different battery cells. The different CSCs of a battery system are connected to each other with a wiring harness that allows to interconnect the CSCs within a bus system. Via this wiring harness, the different CSCs may communicate with each other and with a master electronic control unit, ECU, which is often also denoted as a battery management system, BMS. The master ECU or BMS may read out and control the different CSCs of the battery system, communicating with the CSCs via the wiring harness.

Moreover, in some battery systems of the state of the art, an additional wiring harness is required for the electrical connection of the different battery cells or modules to the CSCs. In other battery systems, the electrical connection between the different battery cells or modules and the CSCs is provided via another electrical interconnection technology. For example, the battery cells or modules may be screwed or bonded to the CSCs or vice versa.

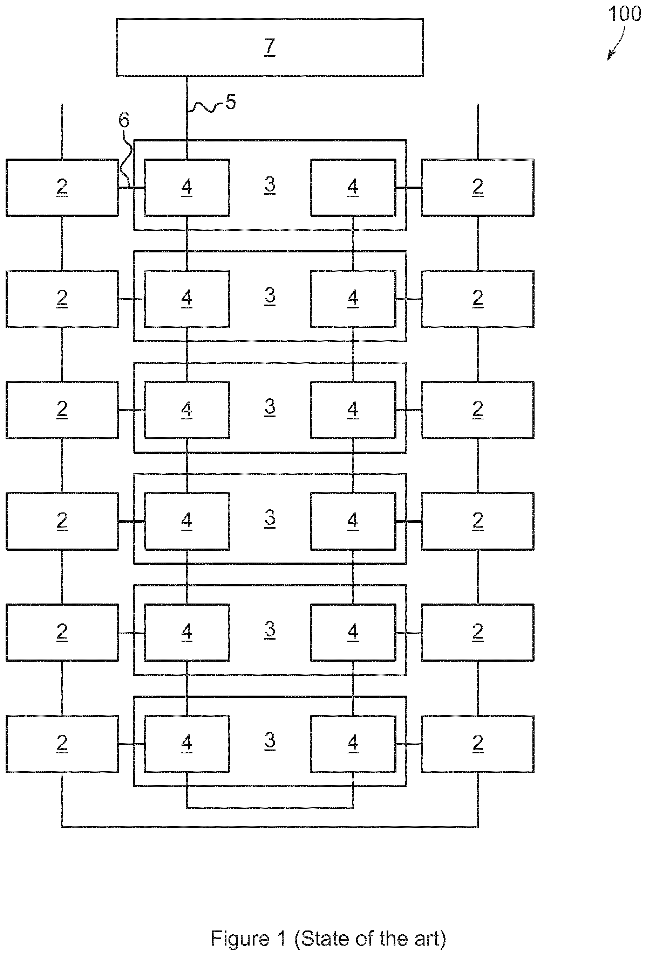

In figure 1, an example of such a battery system 100 of the state of the art is illustrated. The battery system 100 shown in figure 1 comprises a plurality of battery cells which are provided in 12 battery modules 2. Within these battery modules 2, the battery cells may be series connected or (partly) connected in parallel. Six CSCs 3 are allocated to two of these battery modules 2 respectively, wherein in this example, the battery modules 2 are electrically connected to specific interface chips 4 of the CSCs 3 via a second wiring harness 6. Via a first wiring harness 5, the interface chips 4 of the CSCs 3 and hence the CSCs 3 are electrically connected to each other and to an electronic control unit, ECU 7, which in this example of the state of the art corresponds to a master battery management system, BMS. Via the first wiring harness 5, the CSCs 3 and the BMS are electrically interconnected within a bus system having a so called Daisy chain topology. The first wiring harness 5 allows for the BMS to control the CSCs 3 and to receive information, e.g. the cell voltage values or the cell temperature values of the respective battery cells or modules measured by the CSCs 3 and transmitted via the interface chips 4 of the CSCs 3. The battery system 100 provides for a first high voltage potential HV+ via a first power line at a first battery system terminal (not shown in figure 1) and for a second high voltage potential HV- via a second power line at a second battery system terminal (not shown in figure 1). The first and second power lines are each electrically interconnecting the battery modules 2 of the battery system 100 respectively. Document US2012/0112706 discloses an example of such prior art battery system.

However, in all of the aforementioned battery systems, at least one wiring harness comes to use which increases the overall costs of manufacturing, as the battery system comprises more expensive components that need to be assembled.

It is thus an object of the present invention to overcome or reduce at least some of the drawbacks of the prior art and to provide a battery system that does not require a wiring harness at all.

### Summary of Invention

One or more of the drawbacks of the prior art could be avoided or at least reduced by means of the present invention. In particular, a battery system is provided, the battery system comprises two system terminals for the connection to a load, respectively. Moreover, the battery system comprises a plurality of battery cells, each battery cell comprising two cell terminals electrically connected to one of the two system terminals via one of two power lines, respectively. At least some of the battery cells further comprise an internal cell supervision circuit, iCSC, arranged within said battery cells respectively, wherein each of the iCSCs is adapted to detect at least one parameter of the battery cell it is arranged in. The battery system further comprises a battery management system, BMS, connected to the two power lines, the BMS being adapted to communicate bidirectionally with the iCSCs via the power lines. The iCSCs are further adapted to perform a balancing of the state of charge, SOC, of the battery cells the iCSCs are arranged in respectively.

In such an embodiment, one separate iCSC is provided per battery cell. Preferably, every battery cell of the battery system comprises an own iCSC that is integrated therein, such that a separate wiring harness and a PCB is not required anymore, as the communication between the iCSCs within the battery cells and the battery management system, BMS, can be performed via the power lines, using power line communication techniques. Via the chip internal balancing or the iCSC internal balancing of the SOC of the battery cells, the operational life time of the battery system can be substantially elongated.

Preferably, at least some of the iCSCs are realized as integrated chips, wherein each integrated chip is provided within a housing of a battery cell respectively. Moreover preferred, each integrated chip is provided within a casing of a battery cell respectively. In such an embodiment, the battery system can be provided in a compact size and dimension, as additional space for additional wiring harnesses and PCBs is not required.

In a preferred embodiment, the at least one parameter detectable by the iCSCs comprises the voltage and/or the temperature of the battery cell. In a furthermore preferred embodiment, the parameter detectable by the iCSCs comprises the cell voltage and/or the open circuit voltage, OCV, of the battery cell. In such an embodiment, each iCSC can control and monitor especially the safety critical parameters of the battery cell the respective iCSC is allocated to. Preferably, each iCSC comprises an internal temperature sensor and/or an internal voltage sensor. Furthermore preferred, the aforementioned iCSCs are realized as an integrated chip respectively and the internal temperature sensors and/or the internal voltage sensors are provided on and/or integrated on the integrated chips respectively.

Preferably, at least some of the iCSCs comprise an analog-to-digital converter, ADC, respectively, wherein the ADCs allow for a conversion of a measured analog voltage of a battery cell into digital values respectively. In such an embodiment, analogously measured values can be converted to digital data that more easily can be communicated to the BMS.

In a preferred embodiment, each iCSC is adapted to reduce the state of charge, SOC, of the battery cell the iCSC is arranged in respectively by a discharge of the respective battery cell through an electrical component. In such an embodiment, the states of charge of the battery cells of the battery system may advantageously be adjusted to one another such that an ameliorated operation of the battery system with an elongated lifetime becomes possible.

Preferably, the electrical component is a resistor or a MOSFET, especially a linear controlled MOSFET. In such an embodiment, a more efficient balancing of the battery cells is enabled.

In a preferred embodiment, the iCSCs each comprise a non-volatile memory adapted to store usage logging data of the respective battery cell. In such an embodiment, the usage history of every battery cell comprising an iCSC can be documented which allows e.g. for an improved analysis in case a failure arises during operation of the battery cells, for example due to a misuse of the respective battery cell.

Preferably, the iCSCs are adapted to store usage logging data of the battery cells within the non-volatile memories respectively, wherein the usage logging data comprises the minimum and/or maximum voltage of a battery cell that occurred during a predefined period of the operating time of the battery cell, and/or the minimum and/or maximum temperature of a battery cell that occurred during a predefined period of the operating time of the battery cell. Preferably, the iCSCs are adapted to generate an alarm signal in case a minimum and/or a maximum voltage falls under or above a predetermined threshold and/or in case a minimum and/or maximum temperature falls under or above a predetermined threshold. Furthermore preferred, the iCSCs are adapted to communicate the generated alarm signal to the BMS via the power lines respectively. In such an embodiment, the usage logging data stored or storable by the iCSCs is in particular useful for the detection of critical states of the different battery cells, for example a state in which the battery cells are overcharged respectively.

In a preferred embodiment, each iCSC is further adapted to measure a battery cell current or to receive information about a value of a measured battery cell current via one of the two power lines, respectively. In such an embodiment, the measured battery cell current or the received information about a value of a measured battery cell current can be used to detect further states of the battery cells, respectively. Preferably, the battery cell current is defined as the current that flows from a terminal of a battery cell to one of the two power lines.

Preferably, each iCSC is further adapted to calculate at least one state of the battery cell the iCSC is arranged in respectively. Preferably, each iCSC is further adapted to determine and/or to detect at least one state of the battery cell the iCSC is arranged in respectively. Furthermore preferred, each iCSC is adapted to store information or data about the calculated and/or determined and/or detected at least one state of the battery cell within its non-volatile memory. This allows storing information or data about specific states of a battery cell within the battery cell itself, respectively. Hence, the information or data about the specific states may be stored in a memory that is independent of the BMS or a memory or storage thereof. Thus, such stored usage logging data may be used e.g. for the decision whether a reclamation of a battery cell is justified or not. Without such usage logging data and the aforementioned feature, it may be difficult to evaluate whether for example an extraordinary short lifetime of a battery cell is related to the respective battery cell itself or to a misuse of the battery cell. In the state of the art, such usage logging data was often stored to a memory provided within a battery management system of the state of the art. However, such battery management systems and the data stored in memories thereof may easily be manipulated and in general the operation of such battery management systems of the state of the art was/is often prone to failures.

In a preferred embodiment, the at least one state of the battery cell comprises the state of charge, SOC, the state of health, SOH, and/or the state of power, SOP, of the battery cell. In such an embodiment, the aforementioned evaluation is very precise.

In a preferred embodiment, the iCSCs are powered by the battery cells in which the iCSCs are arranged in, respectively.

Preferably, each iCSC comprises a wake up circuit, adapted to transfer an iCSC from a sleep mode to an operational mode upon the reception of a wake up signal, respectively. In such an embodiment, the battery system may advantageously be operated in an energy saving mode or a sleep mode and in a normal operation mode. Preferably, the components, units and modules of an iCSC are inactive in the sleep mode and active in the normal operation mode.

In a preferred embodiment, each iCSC further comprises means configured for a reference electrode measurement of the battery cell the iCSC is arranged in respectively. Furthermore preferred, each iCSC is adapted to detect the occurrence of lithium plating. Moreover preferred, each iCSC is adapted to detect the occurrence of lithium plating of an anode of the battery cell the respective iCSC is arranged in. In such an embodiment, lithium plating and hence the undesirable deposition of lithium ions at e.g. the anode layer of a battery cell can be efficiently avoided as it can be detected when or before it arises or occurs. Upon a successful detection, counter measures may be initiated.

Preferably, each iCSC further comprises an internal pressure sensor adapted to detect whether an internal pressure of the battery cell the iCSC is arranged in surpasses a predetermined threshold. In such an embodiment, a more safe operation of the battery system can be assured as the occurrence of e.g. an overpressure of a battery cell may be detected early and before it causes any damage to the respective battery cell.

In a preferred embodiment, the battery cells each comprise a jelly roll assembly respectively, wherein each iCSC is electrically connected to a temperature sensor respectively, the temperature sensors being provided within or next to the jelly roll assemblies of the battery cells respectively, wherein the iCSCs are adapted to measure the temperature using the temperature sensors respectively. In such an embodiment, an even more safe operation of the battery system can be assured as the temperatures of the jelly rolls of the battery cells may be measured with a higher precision. Especially, the detection of the SOP and the SOH of a battery cell via an iCSC may be improved.

In a preferred embodiment, the BMS is adapted for a control and/or a supervision of the battery cells comprising an iCSC respectively.

Preferably, an iCSC is provided in every battery cell of the battery system.

Further aspects of the present invention could be learned from the dependent claims or the following description.

### Brief Description of the Drawings

Features will become apparent to those of ordinary skill in the art by describing in detail exemplary embodiments with reference to the attached drawings in which:
- Fig. 1: illustrates an example of a battery system of the state of the art;
- Fig. 2: schematically illustrates an exemplarily embodiment of a battery system according to the invention, and
- Fig. 3: schematically illustrates an exemplary embodiment of a battery cell of the embodiment of a battery system as shown in figure 2.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention."

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention.

In the following description of embodiments of the present invention, the terms of a singular form may include plural forms unless the context clearly indicates otherwise.

It will be further understood that the terms "include," "comprise," "including," or "comprising" specify a property, an element, a component, and a combination thereof but do not exclude other properties, elements, components, and combinations thereof.

It will also be understood that when an element is referred to as being "above" or "on" another element, it can be directly on the other element, or intervening elements may also be present.

It will further be understood that when an element is referred to as being "on," "connected to," or "coupled to" another element, it can be directly on, connected to, or coupled to the other element, or one or more intervening elements may be present. In addition, it will also be understood that when an element is referred to as being "between" two elements, it can be the only element between the two elements, or one or more intervening elements may also be present.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

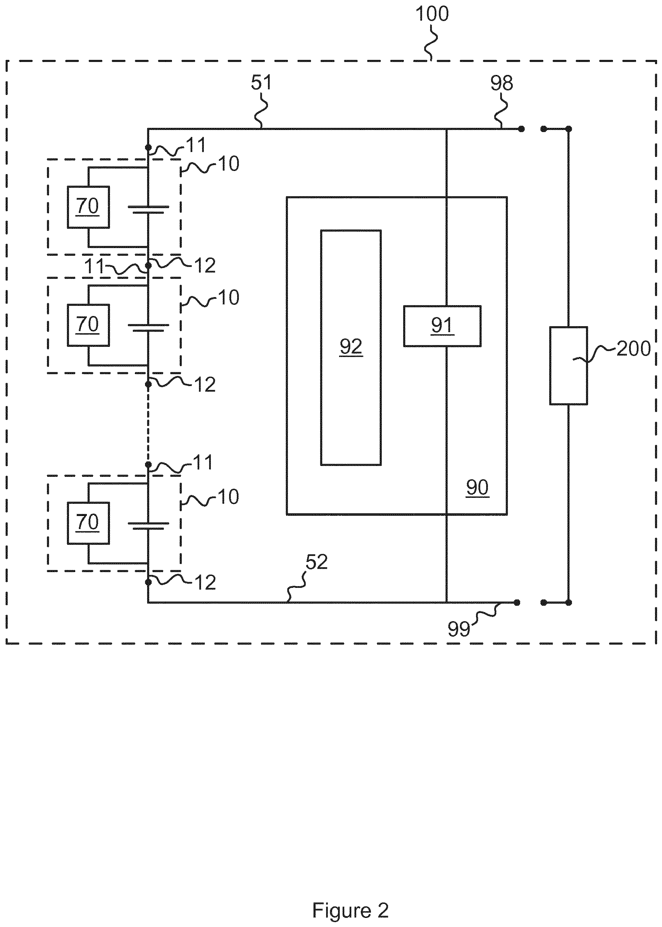

In figure 2 an exemplarily embodiment of a battery system 100 according to the invention is schematically illustrated. The battery system 100 in this exemplary embodiment comprises two system terminals 98, 99 which are adapted for the connection to a load 200, which in figure 2 is exemplarily and schematically illustrated in a disconnected state. The battery system 100 further comprises a plurality of battery cells 10 which in this embodiment are exemplarily series connected and merely schematically indicated via a dashed line respectively. However, the battery cells of another battery system that is according to the invention may also be connected in parallel or in series and in parallel to each other. In the embodiment shown in figure 2, each battery cell 10 comprises two cell terminals 11, 12 electrically connected to one of the two system terminals 98, 99 via one of two power lines 51, 52, respectively. Hence, each power line 51, 52 is electrically connected to one of the system terminals 98, 99 respectively. In this embodiment, all battery cells 10 further comprise an internal cell supervision circuit, iCSC 70, arranged within said battery cells 10 respectively. In this embodiment, each of the iCSCs 70 is adapted to detect a plurality of parameters of the battery cell 10 it is arranged in, respectively. In the embodiment shown in figure 2, each iCSC 70 is supplied with power by the battery cell 10 the respective iCSC 70 is arranged in. Thus, first terminals of the iCSCs 70 are electrically connected to the anodes of the battery cells 10 the iCSCs 70 are arranged in respectively and second terminals of the iCSCs 70 are electrically connected to the cathodes of the battery cells 10 the iCSCs 70 are arranged in respectively, such that - via their respective input terminals - the iCSCs 70 are electrically connected to the cell terminals 11, 12 of the battery cells 10 the iCSCs 70 are arranged in respectively. Furthermore, in this embodiment, the iCSCs 70 are realized as integrated circuits, ICs, which are provided as an integrated chip on a die, respectively. Each integrated chip is provided within a housing / case of a battery cell 10, respectively.

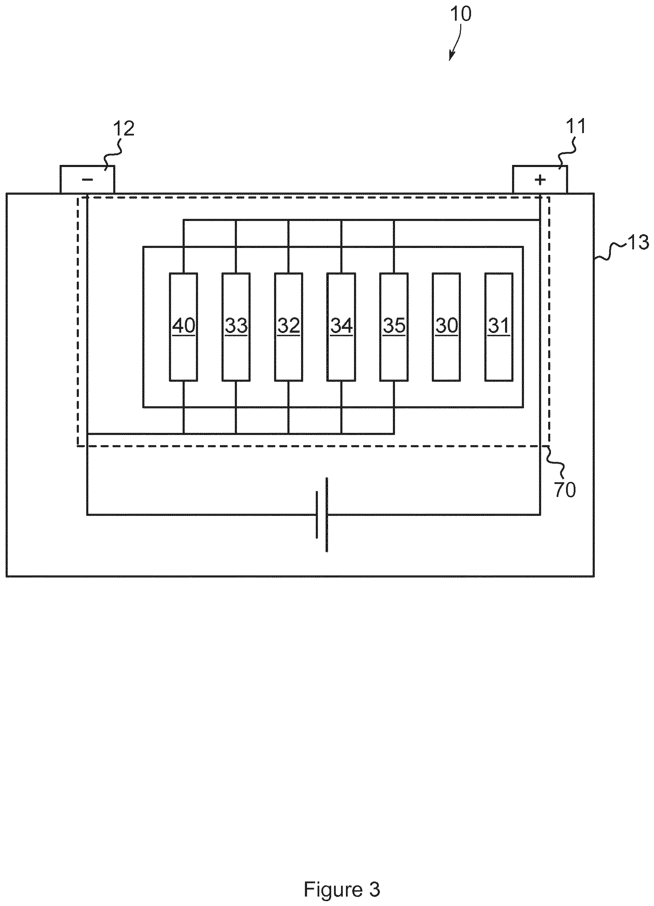

The functionality and components of the iCSCs 70 will be described in greater detail with respect to figure 3. The battery system 10 shown in figure 2 further comprises a battery management system, BMS 90, connected to the two power lines 51, 52 via input terminals of the BMS 90 respectively. Hence, a first terminal of the BMS 90 is electrically connected to the power line 51 that is directly electrically connected to the first system terminal 98 of the battery system 100, wherein a second terminal of the BMS 90 is electrically connected to the power line 52 that is directly electrically connected to the second system terminal 99 of the battery system 100. The first terminal and the second terminal of the BMS 90 are electrically connected to a receiver circuit 91 of the BMS 90, the receiver circuit 91 being adapted for power line communication and hence to transmit and receive data to and from the iCSCs 70 of the battery cells 10 via the power lines 51, 52 respectively. In more detail, via the receiver circuit 91, the BMS 90 is adapted to communicate bidirectionally with the iCSCs 70 via the power lines 51, 52 performing power line communication. Via the iCSCs 70 connected to the power lines 51, 52, the BMS 90 is adapted to control and monitor the battery cells 10 of the battery system 100 via signals that may be transmitted from the BMS 90 to the iCSCs 70 and vice versa. Among others in order to provide for the aforementioned control and monitoring functionality of the BMS 90, the BMS 90 in this embodiment exemplarily comprises a microcontroller 92 that - among others - is adapted to generate control signals and to evaluate signals received from the different iCSCs 70 of the different battery cells 10. However, in other embodiments, such a microcontroller 92 may not come to use, but e.g. a microprocessor, a processor, a digital signal processor or the like. The iCSCs 70 are further adapted to perform a balancing of the state of charge, SOC, of the battery cells 10 the iCSCs 70 are arranged in respectively. In this embodiment, each iCSC 70 is exemplarity adapted to discharge the battery cell 10 the iCSC 70 is arranged in by connecting a resistor between the cell terminals 11, 12 of the respective battery cell 10 respectively. However, in other embodiments that are also according to the invention, iCSCs may also be adapted to perform another kind of balancing using other electronic components, e.g. MOSFETs or the like.

In figure 3, one of the battery cells 10 of the embodiment of the battery system 100 as shown in figure 2 is schematically illustrated. The other battery cells 10 of the battery system 100 shown in figure 2 correspond to the battery cell 10 shown in figure 3. Thus, what is described about the single battery cell 10 shown in figure 3 is also valid for all the other battery cells 10 shown (and not shown) in figure 2 and vice versa. The battery cell 10 shown in figure 3 comprises a housing 13 with a jelly roll assembly that is arranged therein. In figure 3, the jelly roll assembly is merely indicated via a battery symbol. However, the cell terminals 11 and 12 of the battery cell 10 are visible in figure 3. Moreover, the iCSC 70 of the battery cell 10 is schematically indicated in figure 3. As mentioned before, the iCSC 70 is realized as an integrated chip that is arranged within the housing 13 of the battery cell 10. The iCSC 70 comprises a control unit 30 that in this embodiment is exemplarily realized as a microprocessor. However, also other control units may come to use within an iCSC of a battery cell 10. The control unit 30 of the iCSC 70 is adapted to control the other components, modules and units of the iCSC 70 and the communication with the BMS 90. The iCSC 70 further comprises an internal temperature sensor 31 adapted to measure a temperature within the battery cell 10. Moreover, the iCSC 70 comprises a balancing unit 32 adapted to carry out the balancing of the battery cell 10 as described with respect to figure 2. Furthermore, via the balancing unit 32, the open circuit voltage that drops between the cell terminals 11, 12 of the battery cell 10 can be measured. However, in other embodiments, an iCSC may comprise another balancing unit that is not capable of measuring a voltage and/or an additional voltage sensor as a component that is separate from the balancing unit.

Moreover, the iCSC 70 comprises a powerline communication module 33 that allows for the iCSC 70 to communicate and exchange signals with the BMS 90 and vice versa. Furthermore, the iCSC 70 comprises an analog-to-digital converter, ADC 40, which allows for a conversion of a measured analog voltage of the battery cell 10 into digital values respectively. Via a power supply unit 34, the units, components and modules of the iCSC 70 are supplied with power. Further, the iCSC 70 comprises a wake up circuit 35 that is adapted to transfer the iCSC 70 from a sleep mode to an operational mode upon the reception of a wake up signal, respectively. Hence, in this embodiment, the iCSC 70 may be operated in a sleep mode in which the components, units and modules of the iCSC 70 are inactive and in a normal operation mode, in which the aforementioned components, units and modules are active. The transition between the sleep mode and the normal operation mode is initiated when the iCSC 70 receives a wake up signal via the wake up circuit 35, transmitted e.g. by the BMS 90.

In this embodiment, the ADC 40, the powerline communication module 33, the balancing unit 32, the power supply unit 34 and the wake up circuit 35 are electrically connected to the cell terminals 11, 12 of the battery cell 10 via one input terminal per cell terminal 11, 12 respectively.

As can be seen, the iCSC 70 of the battery cell 10 shown in figure 3 and described above comprises a plurality of units, components and modules. However, it is apparent to the person skilled in the art that battery systems 100 which are according to the invention may also be realized without many of the aforementioned components and/or with other components not shown in figure 3 and not described with respect to figure 3.

For example, in the embodiment shown in figures 2 and 3 and described hereinbefore, especially the ADC 40 and/or the wake up circuit 35 and/or the internal temperature sensor 31 are merely optional and may be as well omitted. Furthermore, the iCSC 70 as described hereinbefore may further comprise a unit for a measurement of the battery cell current, a non-volatile memory or storage adapted to store usage logging data and/or a detection and/or evaluation unit for the detection of a specific state of the battery cell 10, e.g. the SOH and/or the SOP or any other state SOx of the battery cell 10. Furthermore, one or more internal pressure sensors and/or one or more (additional) internal or external temperature sensors may be provided with the iCSCs 70 of the battery cell 10. Such internal or external temperature sensors may be provided within or in the proximity of the jelly roll assembly of the battery cell 10.

## Claims

1. A battery system (100), comprising:
two system terminals (98, 99) for the connection to a load (200), respectively;
a plurality of battery cells (10), each battery cell (10) comprising two cell terminals (11, 12) electrically connected to one of the two system terminals (98, 99) via one of two power lines (51, 52), respectively,
wherein at least some of the battery cells (10) further comprise an internal cell supervision circuit, iCSC (70), arranged within said battery cells (10) respectively, wherein each of the iCSCs (70) is adapted to detect at least one parameter of the battery cell (10) it is arranged in; and
a battery management system, BMS (90), connected to the two power lines (51, 52), the BMS (90) being adapted to communicate bidirectionally with the iCSCs (70) via the power lines (51, 52), and wherein the iCSCs (70) are further adapted to perform a balancing of the state of charge, SOC, of the battery cells (10) the iCSCs (70) are arranged in, respectively.

2. The battery system (100) of claim 1, wherein at least some of the iCSCs (70) are realized as integrated chips, wherein each integrated chip is provided within a housing of a battery cell (10) respectively.

3. The battery system (100) of any one of the previous claims, wherein the at least one parameter detectable by the iCSCs (70) comprises the voltage and/or the temperature of the battery cell (10).

4. The battery system (100) of any one of the previous claims, wherein at least some of the iCSCs (70) comprise an analog-to-digital converter, ADC, respectively, wherein the ADCs allow for a conversion of a measured analog voltage of a battery cell (10) into digital values respectively.

5. The battery system (100) of any one of the previous claims, wherein each iCSC (70) is adapted to reduce the state of charge, SOC, of the battery cell (10) the iCSC (70) is arranged in, respectively, by a discharge of the respective battery cell (10) through an electrical component.

6. The battery system (100) of claim 5, wherein the electrical component is a resistor or a MOSFET, especially a linear controlled MOSFET.

7. The battery system (100) of any one of the previous claims, wherein the iCSCs (70) each comprise a non-volatile memory adapted to store usage logging data of the respective battery cell (10).

8. The battery system (100) of claim 7, wherein the iCSCs (70) are adapted to store usage logging data of the battery cells (10) within the non-volatile memories respectively, wherein the usage logging data comprises the minimum and/or maximum voltage of a battery cell (10) that occurred during a predefined period of the operating time of the battery cell (10), and/or the minimum and/or maximum temperature of a battery cell (10) that occurred during a predefined period of the operating time of the battery cell (10).

9. The battery system (100) of any one of the previous claims, wherein each iCSC (70) is further adapted to measure a battery cell current or to receive information about a value of a measured battery cell current via one of the two power lines (51, 52), respectively.

10. The battery system (100) of any one of the previous claims, wherein each iCSC (70) is further adapted to calculate at least one state of the battery cell (10) the iCSC (70) is arranged in respectively.

11. The battery system (100) of claim 10, wherein the at least one state of the battery cell (10) comprises the state of charge, SOC, the state of health, SOH, and/or the state of power, SOP, of the battery cell (10).

12. The battery system (100) of any one of the previous claims, wherein each iCSC (70) comprises a wake up circuit (35), adapted to transfer an iCSC (70) from a sleep mode to an operational mode upon the reception of a wake up signal, respectively.

13. The battery system (100) of any one of the previous claims, wherein each iCSC (70) further comprises means configured for a reference electrode measurement of the battery cell (10) the iCSC (70) is arranged in, respectively.

14. The battery system (100) of any one of the previous claims, wherein each iCSC (70) further comprises an internal pressure sensor adapted to detect whether an internal pressure of the battery cell (10) the iCSC (70) is arranged in, surpasses a predetermined threshold.

15. The battery system (100) of any one of the previous claims, wherein
- the battery cells (10) each comprise a jelly roll assembly respectively, and wherein
- each iCSC (70) is electrically connected to a temperature sensor respectively, the temperature sensors being provided within or next to the jelly roll assemblies of the battery cells (10) respectively, wherein the iCSCs (70) are adapted to measure the temperature using the temperature sensors respectively.

## Patentansprüche

1. Ein Batteriesystem (100), aufweisend:
zwei Systemanschlüsse (98, 99) zur jeweiligen Verbindung mit einer Last (200);
eine Vielzahl von Batteriezellen (10), wobei jede Batteriezelle (10) aufweist:
zwei Zellenanschlüsse (11, 12), die jeweils über eine von zwei Energieleitungen (51, 52) mit einem der zwei Systemanschlüsse (98, 99) elektrisch verbunden sind,
wobei zumindest einige der Batteriezellen (10) ferner aufweisen
eine interne Zellenüberwachungsschaltung, iCSC (70), die jeweils in den besagten Batteriezellen (10) angeordnet ist, wobei jede der iCSCs (70) angepasst ist, um zumindest einen Parameter der Batteriezelle (10), in der sie angeordnet ist, zu erfassen; und
ein Batteriemanagementsystem, BMS (90), das mit den zwei Energieleitungen (51, 52) verbunden ist, wobei das BMS (90) angepasst ist, um über die Energieleitungen (51, 52) bidirektional mit den iCSCs (70) zu kommunizieren,
und wobei die iCSCs (70) ferner angepasst sind, um einen Ausgleich des Ladezustands, SOC, der Batteriezellen (10), in denen die iCSCs (70) jeweils angeordnet sind, durchzuführen.

2. Das Batteriesystem (100) nach Anspruch 1, wobei zumindest einige der iCSCs (70) als integrierte Chips realisiert sind, wobei jeder integrierte Chip jeweils in einem Gehäuse einer Batteriezelle (10) bereitgestellt wird.

3. Das Batteriesystem (100) nach einem der vorhergehenden Ansprüche, wobei der zumindest eine Parameter, der von den iCSCs (70) erfasst wird, die Spannung und/oder die Temperatur der Batteriezelle (10) aufweist.

4. Das Batteriesystem (100) nach einem der vorhergehenden Ansprüche, wobei zumindest einige der iCSCs (70) jeweils einen Analog-DigitalWandler, ADC, aufweisen, wobei die ADCs jeweils eine Umwandlung einer gemessenen analogen Spannung einer Batteriezelle (10) in digitale Werte ermöglichen.

5. Das Batteriesystem (100) nach einem der vorhergehenden Ansprüche, wobei jede iCSC (70) angepasst ist, um jeweils den Ladezustand, SOC, der Batteriezelle (10), in der die iCSC (70) angeordnet ist, durch eine Entladung der jeweiligen Batteriezelle (10) durch eine elektrische Komponente zu reduzieren.

6. Das Batteriesystem (100) nach Anspruch 5, wobei die elektrische Komponente ein Widerstand oder ein MOSFET, insbesondere ein linear gesteuerter MOSFET, ist.

7. Das Batteriesystem (100) nach einem der vorhergehenden Ansprüche, wobei die iCSCs (70) jeweils einen nichtflüchtigen Speicher, der angepasst ist, um Benutzerprotokollierungsdaten der jeweiligen Batteriezelle (10) zu speichern, aufweisen.

8. Das Batteriesystem (100) nach Anspruch 7, wobei die iCSCs (70) angepasst sind, um Benutzerprotokollierungsdaten der Batteriezellen (10) jeweils in den nichtflüchtigen Speichern zu speichern, wobei die Benutzerprotokollierungsdaten die minimale und/oder maximale Spannung einer Batteriezelle (10), die während einer vorgegebenen Zeitdauer der Betriebszeit der Batteriezelle (10) auftrat, und/oder die minimale und/oder maximale Temperatur einer Batteriezelle (10), die während einer vorgegebenen Zeitdauer der Betriebszeit der Batteriezelle (10) auftrat, aufweisen.

9. Das Batteriesystem (100) nach einem der vorhergehenden Ansprüche, wobei jede iCSC (70) ferner angepasst ist, um jeweils über eine der zwei Energieleitungen (51, 52) einen Batteriezellenstrom zu messen oder Informationen über einen Wert eines gemessenen Batteriezellenstroms zu empfangen.

10. Das Batteriesystem (100) nach einem der vorhergehenden Ansprüche, wobei jede iCSC (70) ferner angepasst ist, um zumindest einen Zustand der Batteriezelle (10), in der die iCSC (70) jeweils angeordnet ist, zu berechnen.

11. Das Batteriesystem (100) nach Anspruch 10, wobei der zumindest eine Zustand der Batteriezelle (10) den Ladezustand, SOC, den Alterungszustand, SOH, und/oder den Leistungszustand, SOP, der Batteriezelle (10) aufweist.

12. Das Batteriesystem (100) nach einem der vorhergehenden Ansprüche, wobei jede iCSC (70) eine Aufweckschaltung (35), die angepasst ist, um nach Empfang eines Aufwecksignals jeweils eine iCSC (70) von einem Schlafmodus in einen Betriebsmodus zu überführen, aufweist.

13. Das Batteriesystem (100) nach einem der vorhergehenden Ansprüche, wobei jede iCSC (70) ferner Mittel, die für eine Referenzelektrodenmessung der Batteriezelle (10), in der die iCSC (70) jeweils angeordnet ist, konfiguriert sind, aufweist.

14. Das Batteriesystem (100) nach einem der vorhergehenden Ansprüche, wobei jede iCSC (70) ferner einen Innendrucksensor, der angepasst ist, um zu erfassen, ob ein Innendruck der Batteriezelle (10), in der die iCSC (70) angeordnet ist, eine vorbestimmte Schwelle überschreitet, aufweist.

15. Das Batteriesystem (100) nach einem der vorhergehenden Ansprüche, wobei
- alle Batteriezellen (10) jeweils eine gewickelte Anordnung aufweisen, und wobei
- jede iCSC (70) jeweils mit einem Temperatursensor elektrisch verbunden ist, wobei die Temperatursensoren jeweils in oder nahe den gewickelten Anordnungen der Batteriezellen (10) bereitgestellt werden, wobei die iCSCs (70) angepasst sind, um die Temperatur jeweils mittels der Temperatursensoren zu messen.

## Revendications

1. Système de batterie (100), comprenant :
deux bornes de système (98, 99) pour être reliées à une charge (200), respectivement ;
une pluralité de cellules de batterie (10), chaque cellule de batterie (10) comprenant :
deux bornes de cellule (11, 12) reliées électriquement à l'une des deux bornes de système (98, 99) via l'une de deux lignes d'alimentation (51, 52), respectivement,
où au moins certaines des cellules de batterie (10) comprennent en outre :
un circuit de supervision de cellule interne, iCSC (70), agencé à l'intérieur desdites cellules de batterie (10) respectivement, où chacun des circuits iCSC (70) est conçu pour détecter au moins un paramètre de la cellule de batterie (10) dans laquelle il est agencé ; et
un système de gestion de batterie, BMS (90), relié aux deux lignes d'alimentation (51, 52), le système BMS (90) étant conçu pour communiquer de manière bidirectionnelle avec les circuits iCSC (70) via les lignes d'alimentation (51, 52), et
où les circuits iCSC (70) sont en outre conçus pour effectuer un équilibrage de l'état de charge, SOC, des cellules de batterie (10) dans lesquelles sont agencés les circuits iCSC (70), respectivement.

2. Système de batterie (100) de la revendication 1, dans lequel au moins certains des circuits iCSC (70) sont réalisés sous forme de puces intégrées, où chaque puce intégrée est prévue dans un boîtier d'une cellule de batterie (10) respectivement.

3. Système de batterie (100) de l'une quelconque des revendications précédentes, dans lequel l'au moins un paramètre pouvant être détecté par les circuits iCSC (70) comprend la tension et/ou la température de la cellule de batterie (10).

4. Système de batterie (100) de l'une quelconque des revendications précédentes, dans lequel au moins certains des circuits iCSC (70) comprennent un convertisseur analogique-numérique, ADC, respectivement, où les convertisseurs ADC permettent une conversion d'une tension analogique mesurée d'une cellule de batterie (10) en des valeurs numériques respectivement.

5. Système de batterie (100) de l'une quelconque des revendications précédentes, dans lequel chaque circuit iCSC (70) est conçu pour réduire l'état de charge, SOC, de la cellule de batterie (10) dans laquelle est agencé le circuit iCSC (70), respectivement, par une décharge de la cellule de batterie respective (10) par l'intermédiaire d'un composant électrique.

6. Système de batterie (100) de la revendication 5, dans lequel le composant électrique est une résistance ou un MOSFET, en particulier un MOSFET à commande linéaire.

7. Système de batterie (100) de l'une quelconque des revendications précédentes, dans lequel les circuits iCSC (70) comprennent chacun une mémoire non volatile conçue pour stocker des données de journalisation d'utilisation de la cellule de batterie respective (10).

8. Système de batterie (100) de la revendication 7, dans lequel les circuits iCSC (70) sont conçus pour stocker des données de journalisation d'utilisation des cellules de batterie (10) dans les mémoires non volatiles respectivement, où les données de journalisation d'utilisation comprennent la tension minimale et/ou maximale d'une cellule de batterie (10) qui s'est produite pendant une période prédéfinie de la durée de fonctionnement de la cellule de batterie (10), et/ou la température minimale et/ou maximale d'une cellule de batterie (10) qui s'est produite pendant une période prédéfinie de la durée de fonctionnement de la cellule de batterie (10).

9. Système de batterie (100) de l'une quelconque des revendications précédentes, dans lequel chaque circuit iCSC (70) est en outre conçu pour mesurer un courant de cellule de batterie ou pour recevoir des informations concernant une valeur d'un courant de cellule de batterie mesuré via l'une des deux lignes d'alimentation (51, 52), respectivement.

10. Système de batterie (100) de l'une quelconque des revendications précédentes, dans lequel chaque circuit iCSC (70) est en outre conçu pour calculer au moins un état de la cellule de batterie (10) dans laquelle est agencé le circuit iCSC (70) respectivement.

11. Système de batterie (100) de la revendication 10, dans lequel l'au moins un état de la cellule de batterie (10) comprend l'état de charge, SOC, l'état de santé, SOH, et/ou l'état de puissance, SOP, de la cellule de batterie (10) .

12. Système de batterie (100) de l'une quelconque des revendications précédentes, dans lequel chaque circuit iCSC (70) comprend un circuit d'activation (35), conçu pour transférer un circuit iCSC (70) d'un mode veille à un mode fonctionnel lors de la réception d'un signal d'activation, respectivement.

13. Système de batterie (100) de l'une quelconque des revendications précédentes, dans lequel chaque circuit iCSC (70) comprend en outre un moyen configuré pour une mesure d'électrode de référence de la cellule de batterie (10) dans laquelle est agencé le circuit iCSC (70) respectivement.

14. Système de batterie (100) de l'une quelconque des revendications précédentes, dans lequel chaque circuit iCSC (70) comprend en outre un capteur de pression interne conçu pour détecter si une pression interne de la cellule de batterie (10) dans laquelle est agencé le circuit iCSC (70), dépasse un seuil prédéterminé.

15. Système de batterie (100) de l'une quelconque des revendications précédentes, dans lequel
- les cellules de batterie (10) comprennent chacune un ensemble de type roulé respectivement, et où
- chaque circuit iCSC (70) est relié électriquement à un capteur de température respectivement, les capteurs de température étant prévus à l'intérieur ou à côté des ensembles de type roulé des cellules de batterie (10) respectivement, où les circuits iCSC (70) sont conçus pour mesurer la température en utilisant les capteurs de température respectivement.
